# EUROPÄISCHE PATENTSCHRIFT

(11) **EP 3 149 766 B1**
(45) Veröffentlichungstag und Bekanntmachung des Hinweises auf die Patenterteilung: **20.12.2017**
(21) Anmeldenummer: 15774605.8
(22) Anmeldetag: 01.10.2015
(51) Int. Cl.: H01L 21/28, G11C 16/04, H01L 29/423, H01L 29/788, H01L 29/66

(54) **FLASH-SPEICHERZELLE UND VERFAHREN ZU IHRER HERSTELLUNG**
FLASH MEMORY CELL AND METHOD FOR ITS PRODUCTION
CELLULE DE MÉMOIRE FLASH ET SON PROCÉDÉ DE FABRICATION

(30) Priorität: 02.10.2014 EP 14187533; 30.10.2014 EP 14191155
(43) Veröffentlichungstag der Anmeldung: 05.04.2017
(73) Patentinhaber: Elmos Semiconductor Aktiengesellschaft, 44227 Dortmund (DE)
(72) Erfinder: KLEINING, Tobias, 44227 Dortmund (DE); VAITKEVITCH, Sergej, 44227 Dortmund (DE); HOFMANN, Martin, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2015/072726
(87) Internationale Veröffentlichungsnummer: WO 2016/050927

(56) Entgegenhaltungen:
- EP-A2- 0 373 830
- US-A- 5 879 990
- US-A1- 2010 078 703
- US-A1- 2013 099 301

## Beschreibung

Die Erfindung betrifft eine Flash-Speicherzelle sowie ein Verfahren zur Herstellung einer solchen Flash-Speicherzelle.

Flash-Speicherzellen zur Speicherung eines oder mehrerer Bits sind grundsätzlich bekannt. Sie verfügen im Regelfall über ein Floating-Gate, das die binäre Information bzw. die binären Informationen speichert (nachfolgend auch Speicherelement genannt), und das kapazitiv an ein Steuer-Gate gekoppelt ist. Beide Gates sind durch jeweils eine Gate-Isolationsschicht ggf. unterschiedlicher Dicke gegenüber dem Kanalgebiet eines Halbleitersubstrats, das zwischen einem Drain- und einem Source-Anschlussgebiet angeordnet ist, isoliert. Durch Ausnutzung des Tunneleffekts lässt sich nun Ladung in das Speicherelement einbringen bzw. auch wieder entnehmen. Je nach Ladungszustand speichert das Speicherelement eine von mindestens zwei binären Informationen.

Flash-Speicherzellen gemäß dem Oberbegriff des Anspruchs 1 sind in US-A-2013/0099301 und US-A-5 879 990 beschrieben. In US-A-2010/0078703 und EP-A-0 373 830 sind Maßnahmen beschrieben, um bei split-gate Speicherzellen die Schwellspannungen von Steuertransistor und Speichertransistor z.B. durch Gegendotierung getrennt einzustellen.

Wünschenswert bei Flash-Speicherzellen ist es, dass die gespeicherte binäre Information möglichst lange und insbesondere auch bei erhöhten Umgebungstemperaturen gespeichert bleibt.

Aufgabe der Erfindung ist es, eine Flash-Speicherzelle anzugeben, bei der die binäre Information auch bei erhöhten Temperaturen über einen ausreichend langen Zeitraum korrekt auslesbar bleibt. Eine weitere Aufgabe ist es, dass diejenigen nicht-selektierten Flash-Speicherzellen einer Bitleitung, deren binäre Information (bei angelegter Lesespannung am Steuer-Gate) durch Nicht-Sperren des Stromflusses durch die Zelle repräsentiert ist, auch dann zuverlässig sperren, wenn die Lesespannung nicht angelegt ist. Beides sollte über einen erweiterten bzw. erhöhten Temperaturbereich von bspw. über 125°C und bis zu 170°C gewährleistet sein. Ferner ist es Aufgabe der Erfindung, ein Verfahren zur Herstellung einer derartigen Flash-Speicherzelle anzugeben.

Zur Lösung der erstgenannten Aufgabe wird mit der Erfindung eine Flash-Speicherzelle, die durch Anlegen von Programmier- und Löschspannungen beschreibbar sowie löschbar und durch Anlegen einer Lesespannung auslesbar ist, vorgeschlagen, wobei die Flash-Speicherzelle versehen ist mit den Merkmalen des Anspruchs 1. Einzelne Ausgestaltungen der Erfindung sind Gegenstand der jeweiligen Unteransprüche.

Erfindungsgemäß lässt sich eine derartige Flash-Zelle gemäß einem Verfahren herstellen, wie es im Anspruch 6 angegeben ist.

Die erfindungsgemäße Flash-Speicherzelle ist als Floating-Gate-Transistor ausgebildet, der ein Steuer-Gate und ein Floating-Gate aufweist, die, wie bei Floating-Gate-Transistoren an sich üblich, kapazitiv gekoppelt sind. Die Flash-Speicherzelle weist ein Transistor-Kanalgebiet auf, das in der Oberseite eines Halbleitersubstrats und in diesem ausgebildet ist. Über dem Kanalgebiet befindet sich eine Gate-Isolationsschicht, auf der das Speicherelement aus einem Speichermaterial für elektrische Ladung angeordnet ist, die durch Erzeugen eines Tunnelstroms durch den unterhalb des Speicherelements angeordneten Bereich der Gate-Isolationsschicht hindurch elektrisch aufladbar und elektrisch entladbar ist. Bei dem Speichermaterial des Speicherelements (Floating-Gate) handelt es sich beispielsweise um Polysilizium.

Das von der Gate-Isolationsschicht aufragende Speicherelement ist allseitig und auf seiner Oberseite durch ein Dielektrikum überdeckt.

Erfindungsgemäß ist nun dieses Speicherelement (Floating-Gate) außermittig, d.h. dezentral, zwischen den Drain- und Source-Anschlussgebieten angeordnet. Die Bereiche um das Speicherelement herum und insbesondere zwischen dem Speicherelement und dem Drain-Anschlussgebiet einerseits sowie dem Speicherelement und dem Source-Anschlussgebiet andererseits sind von einer Steuertransistor-Gate-Elektrode überdeckt, die das eigentliche Steuer-Gate des Floating-Gate-Transistors bildet und mit der das Floating-Gate kapazitiv gekoppelt ist.

Die Besonderheit der erfindungsgemäßen Flash-Speicherzelle besteht darin, dass sie ein laterales Oberflächen- sowie oberflächennahes Dotierstoffprofil aufweist, um unterhalb des Speicherelements (Floating-Gate) eine wesentlich höhere (z. B. um 50% bis 60% hohen) Schwellspannung einzustellen als unterhalb des Steuer-Gates.

Hintergrund dieser Maßnahme ist, dass die Schwellspannung des Floating-Gates einer Flash-Speicherzelle durch den jeweiligen Ladungszustand des Floating-Gates bestimmt ist. Als "neutraler Zustand" des Floating-Gates wird dabei diejenige Schwellspannung verstanden, bei der dem Floating-Gate weder die eine binäre Information (beispielsweise binär EINS) noch die andere binäre Information (beispielsweise binär NULL) zugeordnet werden kann. Gelingt es nun, den Auslesearbeitspunkt, d. h. die an das Steuer-Gate anzulegende Auslesespannung möglichst zentral zwischen die Schwellspannungswerte für den einen binären Zustand und den anderen binären Zustand zu legen, so können die beiden binären Zustände (beispielsweise binär EINS und binär NULL) durch Aufbringen entsprechend vergleichsweise geringer Ladungen immer noch unterschieden werden. Die elektrische Entladung von Floating-Gates nimmt über die Zeit betrachtet exponentiell ab. Durch die erfindungsgemäßen Implantations-Maßnahmen gelingt es, die gespeicherte Information auch dann noch korrekt auslesen zu können, wenn die Menge an gespeicherter Ladung vergleichsweise gering ist, was im weniger stark abklingenden Bereich der exponentiellen Entladungsfunktion der Fall ist. Das bedeutet, dass die gespeicherte Information über einen wesentlich längeren Zeitraum korrekt ausgelesen werden kann als dies der Fall ist, wenn zur sicheren Unterscheidung der beiden binären Zustände vergleichsweise viel Ladung in dem Floating-Gate gespeichert sein muss.

Um nun die Leckströme auch bei vergleichsweise hohen Temperaturen von bis zu 170°C und darüber vergleichsweise gering zu halten, ist erfindungsgemäß vorgesehen, dass die Kanallänge unter dem Steuer-Gate durch die dezentrale Anordnung des Speicherelements größer ist als bei zentraler Anordnung des Speicherelements zwischen den Drain- und Source-Anschlussgebieten. Dadurch sind die Leckströme, die durch Kurzkanaleffekte verursacht werden, auf einen für diesen zu höheren Temperaturen erweiterten Temperaturbereich auf einen (noch) vertretbaren Rahmen reduziert.

Insgesamt ergibt sich damit unter Verwendung des erfindungsgemäßen Flash-Zellen-Aufbaus eine verbesserte Konstruktion, und zwar dergestalt, dass die gespeicherte binäre Information auch bei erhöhten Temperaturen für längere Zeit gehalten und korrekt ausgelesen werden kann.

Das laterale Dotierstoffprofil auf der Oberseite des Halbleitersubstrats und im oberseitennahen Bereich des Halbleitersubstrats, also im Kanalgebiet zwischen den Drain- und Source-Anschlussgebieten, wird erfindungsgemäß durch eine Doppelimplantation von Dotierstoffen jeweils unterschiedlichen Leitungstyps erzielt. Zunächst wird durch eine Schrägimplantation, ggf. in mehreren Implantationsschritten bei jeweils unterschiedlicher Ausrichtung des Ionenimplantationsbeschusses, unterhalb des Speicherelements ein erster Dotierstoff von einem ersten Leitungstyp eingebracht. Diese Schrägimplantation erfolgt beispielsweise unter einem spitzen Winkel von insbesondere 45° zur Oberseite des Halbleitersubstrats und gelangt von der Seite schräg bis unterhalb des Speicherelements (Floating-Gate) und auch in den übrigen Bereich des Kanals zwischen den Drain- und Source-Anschlussgebieten. Dieser erste Dotierstoff dient der Definition einer vergleichsweise hohen ersten Schwellspannung unterhalb des Speicherelements, wie oben beschrieben. Zur Kompensation dieser hohen ersten Schwellspannung im Bereich des Kanals außerhalb des Speicherelements, also im Bereich des Kanals unterhalb des Steuer-Gates, dient eine Kompensationsimplantation unter im wesentlichen 90° zur Oberseite durch einen zweiten (Kompensations-) Dotierstoff von einem zweiten Leitungstyp, der dem ersten Leitungstyp entgegengesetzt ist. Dadurch wird außerhalb des Speicherelements die Implantation des ersten Dotierstoffs teilweise kompensiert und damit neutralisiert. Außerhalb des Speicherelements weist somit der Steuertransistor der erfindungsgemäßen Flash-Speicherzelle eine wesentlich niedrigere Schwellspannung auf als unterhalb des Speicherelements. Damit "öffnet" der Steuertransistor (Steuer-Gate) bei niedrigen Spannungen, wie sie beispielsweise zum Lesen der Flash-Speicherzelle eingesetzt werden. Die wegen der dezentralen Anordnung des Speicherelements vergrößerte Kanallänge des Steuertransistors sorgt für reduzierte Leckströme, und zwar auch bei erhöhten Temperaturen.

Zusammenfassend können also die beiden wesentlichen Vorteile der Erfindung hinsichtlich der Verringerung der Auswirkungen der beiden bei Flash-Speicherzellen zu beobachtenden Leckstrommechanismen wie folgt umschrieben werden.

Aufgrund eines insbesondere bei hohen Temperaturen zu großen Ladungsverlusts am Floating Gate (Speichermedium) durch Tunnelströme kann eine Zelle nicht mehr eindeutig ausgelesen werden. Die erfindungsgemäße Speicherzelle entschärft den Einfluss des intrinsischen Ladungsverlustes, der durch die Oxiddicke und Qualität festgelegt ist, durch die Anpassung der neutralen Schwelle (neutrale Schwellspannung) des Speichertransistors an die Leseschwelle bzw. -spannung (Implantationsschema), wodurch der "erlaubte" Ladungsverlust vergrößert wird bzw. der initiale Ladungsunterschied nicht mehr so groß sein muss, um die gespeicherte Information immer noch korrekt auslesen zu können.

Beim Auslesen der Zellen einer Bitleitung darf ein Leckstrom von Source zu Drain, der ungewollt zum Signal- bzw. Auslesestrom beiträgt, möglichst nicht auftreten. Aufgrund der Architektur eines Flash-Speichers weist eine Bitleitung mehrere in Reihe geschaltete Speicherzellen auf. Ist der Leckstrom der unselektierten Zellen einer Bitleitung zu groß, kann eine selektierte und z. B. auf "1" programmierte Zelle (Floating- Gate sperrt und Steuer-Gate sperrt, d. h. kein Stromfluss) nicht mehr mit "1" gelesen werden, obwohl der Ladungszustand nicht kritisch ist.

Die erfindungsgemäße Speicherzelle verringert den Einfluss des Leckstroms (Source/Drain) durch die Verlängerung des Steuer-Gates, wodurch das Leckstromniveau gesenkt wird und Zellen auch bei höheren Temperaturen noch eindeutig gelesen werden können. Ferner erhöht die Verringerung der Schwellspannung Vₜ des Steuertransistors, die durch die zweite Implantation bestimmt wird, den "Nutzstrom" der Flash-Speicherzelle.

In weiterer zweckmäßiger Ausgestaltung der Erfindung kann vorgesehen sein, dass das Speicherelement von der Gate-Isolationsschicht höher aufragt als die Steuertransistor-Gate-Elektrode und dass das Speicherelement über seine gesamte Höhe und ggf. darüber hinaus von dem Dielektrikum und der Steuertransistor-Gate-Elektrode umgeben ist.

Zweckmäßig ist es ferner, wenn die Steuertransistor-Gate-Elektrode und insbesondere auch das Speicherelement jeweils polykristallines Silizium aufweist.

Wie bereits oben beschrieben, sollte die Schrägimplantation des ersten Dotierstoffs zur Einbringung desselben in die Oberseite und in den oberseitennahen Bereich des Halbleitersubstrats unterhalb des Speicherelements in mehreren, insbesondere in vier Implantationsschritten erfolgen, wobei der erste Dotierstoff von Implantationsschritt zu Implantationsschritt jeweils in unterschiedlichen, insbesondere gleichmäßig versetzten Raumwinkeln implantiert wird. So ist es beispielsweise bei Einsatz von vier Implantationsschritten möglich, diese in vier um jeweils 90° versetzten Raumwinkelrichtungen unter jeweils 45° zur Oberseite des Halbleitersubstrats einzubringen. Bezogen auf eine Draufsicht auf die Flash-Speicherzelle betrachtet bedeutet dies, dass die vier Implantationsschritte aus Richtung Nord-Ost, aus Richtung Süd-Ost, aus Richtung Süd-West und aus Richtung Nord-West unter jeweils beispielsweise 45° zur Halbleitersubstratoberseite eingeschossen werden.

In weiterer zweckmäßiger Ausgestaltung der Erfindung kann vorgesehen sein, dass das Speicherelement und zumindest die zweite Gate-Isolationsschicht von einem Gate-Elektrodenmaterial überdeckt wird und dass das Gate-Elektrodenmaterial bis in Höhe der Oberseite des aufragenden Speicherelements oder oberhalb dessen heruntergeätzt wird, wobei durch Maskierung des größeren der beiden Abstandsbereiche des Speicherelements zu den Drain- und Source-Anschlussgebieten, der sich zwischen dem Speicherelement und dem Drain-Anschlussgebiet erstreckt, Gate-Elektrodenmaterial zur Erzeugung eines Kanalgebiets auf der Oberseite des Halbleitersubstrats mit einer Länge gebildet wird, die durch den Abstand des Speicherelements zum Drain-Anschlussgebiet definiert ist.

Die Erfindung wird nachfolgend anhand eines Ausführungsbeispiels und unter Bezugnahme auf die Zeichnung näher erläutert. Im Einzelnen zeigen dabei:
- Fig. 1: eine prinzipielle Darstellung eines Ausführungsbeispiels einer erfindungsgemäßen Flash-Speicherzelle bestehend aus Speichertransistor (Floating-Gate) und Steuertransistor (Sidewall-Transistor bzw. Steuer-Gate),
- Fign. 2 bis 21: Darstellungen des nach und nach in mehreren Verfahrensschritten hergestellten Floating-Gate-Transistors der erfindungsgemäßen FlashSpeicherzelle,
- Fign. 22 bis 24: stark schematisiert die Strom-/Spannungskennlinien-Verschiebungen von Flash-Speicherzellen ohne Implantation (Fig. 22), mit Schrägimplantation (Fig. 23) und zusätzlich mit Vertikalimplantation (Fig. 24),
- Fig. 25: eine schematische Darstellung zur Verdeutlichung der Besonderheit der Flash-Speicherzellen zur Verbesserung der Auslesbarkeit der Information auch bei geringen Ladungsmengen und
- Fig. 26: eine schematische Darstellung zur Verdeutlichung der Besonderheit der Flash-Speicherzelle zur Unterdrückung von Leckströmen.

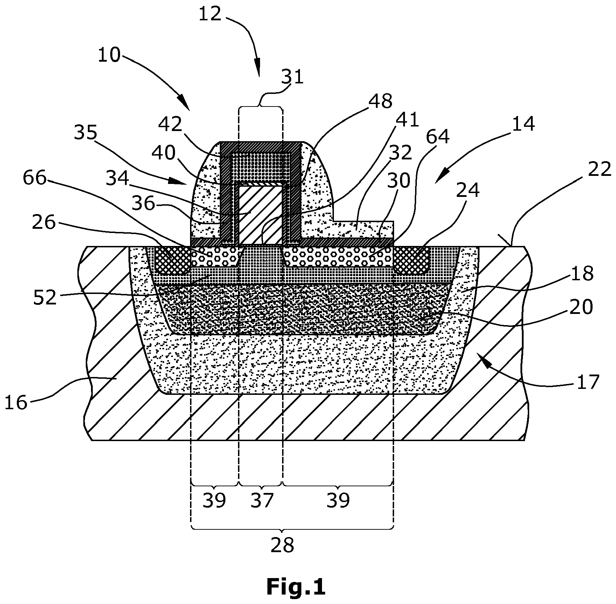

Fig. 1 zeigt den Aufbau einer Flash-Speicherzelle 10 gemäß einem Ausführungsbeispiel der Erfindung, die als Floating-Gate-Transistoranordnung ausgebildet ist. Die Flash-Speicherzelle 10 weist einen Speichertransistor 12 mit dem Floating-Gate als Speicherelement und einen Sidewall- bzw. Steuertransistor 14 mit einem an sich üblichen Steuer-Gate auf.

In einem p-Substrat 16 ist eine Doppelwannenstruktur 17 aus einer ersten tiefen n-Wanne 18 und einer zweiten flachen p-Wanne 20 ausgebildet. Das Halbleitersubstrat 16 weist eine Oberseite 22 auf, auf bzw. in der die Floating-Gate-Transistoranordnung ausgebildet ist. Zu diesem Zweck sind in die p-Wanne 20 ein Drain-Anschlussgebiet 24 und ein Source-Anschlussgebiet 26 eingebracht. Zwischen diesen beiden Anschlussgebieten 24,26 erstreckt sich das Kanalgebiet 28. Ferner befindet sich auf der Oberseite 22 des Halbleitersubstrats 16 eine Gate-Isolationsschicht 30, auf der wiederum die Gate-Elektrode 32 des Steuertransistors 14 angeordnet ist. Ferner befindet sich auf der Gate-Isolationsschicht 30 ein von dieser aufragendes Speicherelement 34 aus einem elektrisch aufladbaren bzw. elektrisch entladbaren Speichermaterial, das das Floating-Gate bildet. Das Speicherelement 34 ist bei 35 von dem Material der Gate-Elektrode 32 des Steuertransistors 14 umgeben, ist aber gegenüber dieser Steuertransistor-Gate-Elektrode 32 durch ein Dielektrikum 36 elektrisch isoliert. Mit anderen Worten sind das Speicherelement 34 und die Gate-Elektrode 32 des Steuertransistors 14 nur kapazitiv gekoppelt.

Wie anhand von Fig. 1 zu erkennen ist, befindet sich das Speicherelement 34 dezentral zwischen dem Source- und dem Drain-Anschlussgebiet 26 bzw. 24. Der unterhalb des Speicherelements 34 befindliche Kanalbereich 37 des Kanalgebietes 28 ist in Abhängigkeit vom Ladungszustand des Speicherelements 34 unterbrochen oder leitend, was sich bei Anlegen der Auslesespannung dadurch zeigt, dass ein Strom fließt (erste binäre Information) oder nicht (zweite binäre Information). Das Kanalgebiet 39 im Bereich unterhalb der Gate-Elektrode 32 wird durch deren Gate-Spannung kontrolliert.

Wie ferner anhand von Fig. 1 zu erkennen ist, ist die Gate-Isolationsschicht 30 im Bereich 31 unterhalb des Speicherelements 34 dünner als unterhalb der Gate-Elektrode 32 des Steuertransistors 14.

Die Gate-Isolationsschicht 30 wirkt in ihrem Bereich 31, d.h. auf dem Kanalbereich 37 unterhalb des Speicherelements 34 als eine Tunnel-Isolationsschicht 41, durch die hindurch auf Grund des Tunneleffekts Ladungen in das Speicherelement 34 eingebracht werden können. Dieser Auf- und Entlade-Mechanismus ist im Zusammenhang mit Floating-Gate-Transistoren und damit im Zusammenhang mit Flash-Speicherzellen grundsätzlich bekannt und soll hier nicht weiter erläutert werden.

Als eine der Besonderheiten der Flash-Speicherzelle 10 kann die dezentrale Anordnung des Speicherelements 34 angesehen werden. Durch diese dezentrale Anordnung wird die wirksame Kanallänge des Steuertransistors 14 vergrößert, was dazu beiträgt, dass sich in denjenigen Zellen einer Bitleitung des Flashspeichers, bei denen nur der Speichertransistor 12 leitend programmier ist und der Steuertransistor 14 durch Anlegen einer entsprechenden Spannung am Steuer-Gate gesperrt ist, die Entstehung der Leckströme verringert.

Als weitere Besonderheit kann angesehen werden, dass innerhalb des Kanalgebiets 28 die Schwellspannung unterhalb des Speicherelements 34, also im Kanalbereich 37 wesentlich höher ist als unterhalb der Steuertransistor-Gate-Elektrode 32, d.h. in den Kanalbereichen 39. Durch diese unterschiedlich eingestellten Schwellspannungen lässt sich das Langzeit-Speicherverhalten der Flash-Speicherzelle 10 positiv beeinflussen, da nämlich mit vergleichsweise geringen gespeicherten Ladungen im Speicherelement 34 gearbeitet werden kann, um binäre Ladungszustände mit ausreichender Zuverlässigkeit voneinander unterscheidbar zu gestalten. Damit bleibt die gespeicherte Information in dem Speicherelement 34 über längere Zeit erhalten, und zwar auch dann, wenn die Flash-Speicherzelle 10 erhöhten Umgebungstemperaturen ausgesetzt ist. Dies wird nachfolgend kurz erläutert.

Grundsätzlich ist es so, dass die Ladung des Speicherelements 34 die Schwellspannung der gesamten Floating-Gate-Transistoranordnung bestimmt. Die Entladecharakteristik des Speicherelements 34 ist, über die Zeit betrachtet, exponentiell abfallend. Das bedeutet, dass die Entladungsrate mit zunehmender Zeit abnimmt. Wenn es nun gelingt, die beiden Zustände "GELÖSCHT" und "PROGRAMMIERT" durch Einbringung einer vergleichsweise geringen Ladungsmenge in das Speicherelement 34 voneinander unterscheiden zu können, bleibt diese sichere Unterscheidung auch über längere Zeit erhalten, d.h. bleibt die gespeicherte Information über längere Zeit erhalten und damit korrekt auslesbar, da sich ja der Ladungszustand des Speicherelements 34 nur noch geringfügig ändert. Damit nun mit vergleichsweise geringen elektrischen Ladungen gearbeitet werden kann, sollte der Auslesearbeitspunkt der Flash-Speicherzelle 10 möglichst in der Mitte zwischen den beiden Strom-Spannungs-Kurven für die Zustände "GELÖSCHT" und "PROGRAMMIERT" liegen. Dies gelingt durch entsprechende Einstellung der Schwellspannung unterhalb des Speicherelements 34.

Damit eine Flash-Speicherzelle schnell ausgelesen werden kann, muss die Zelle entsprechende Stromfähigkeit aufweisen, was durch Anlegen einer entsprechend hohen (z. B. 2,5 V) Selekt-Spannung am Steuer-Gate erfolgt. Diese Spannung wird kapazitiv ans Gate des Speichertransistors, also an das Speicherelement gekoppelt. Die Folge ist, dass die neutrale Schwelle des Speichertransistors entsprechend hoch eingestellt sein sollte.

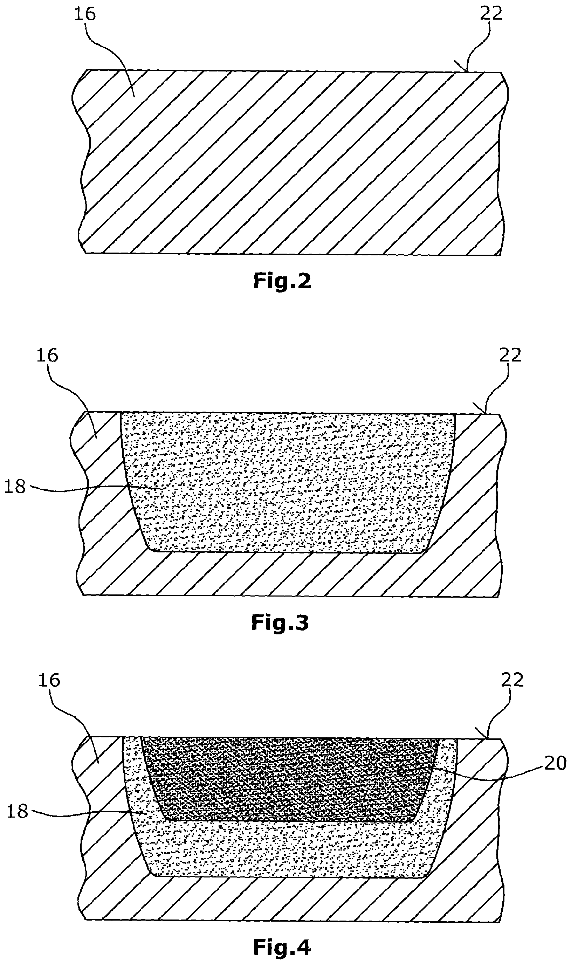

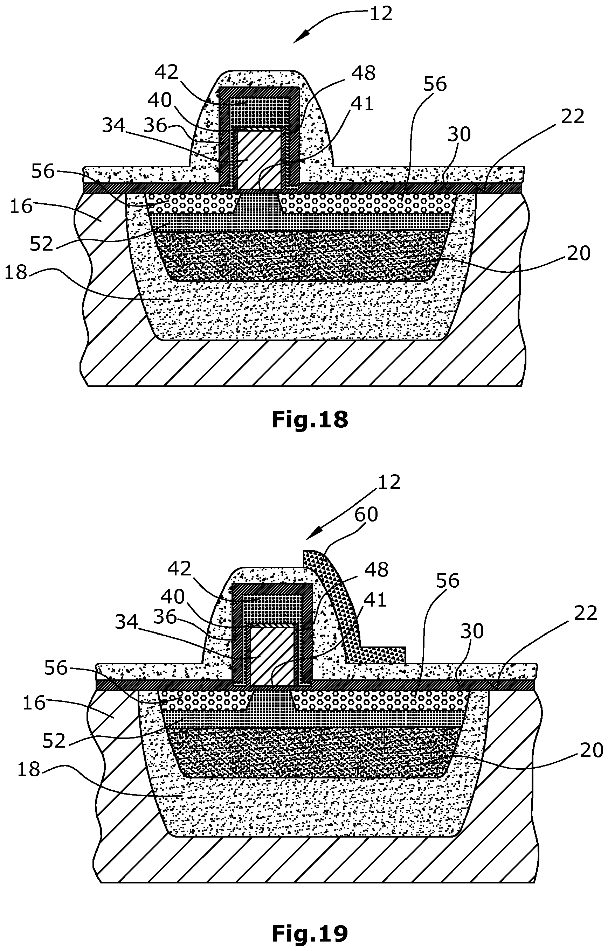

Anhand der Fign. 2 bis 21 soll nachfolgend auf ein Beispiel eines Herstellungsprozesses zur Herstellung der Flash-Speicherzelle 10 eingegangen werden.

Ausgehend von der Situation gemäß Fig. 2 wird in das p-Halbleitersubstrat 16 die n-Wanne 18 eingebracht (siehe Fig. 3). Anschließend wird dann in die n-Wanne 18 die p-Wanne 20 eingebracht (siehe Fig. 4).

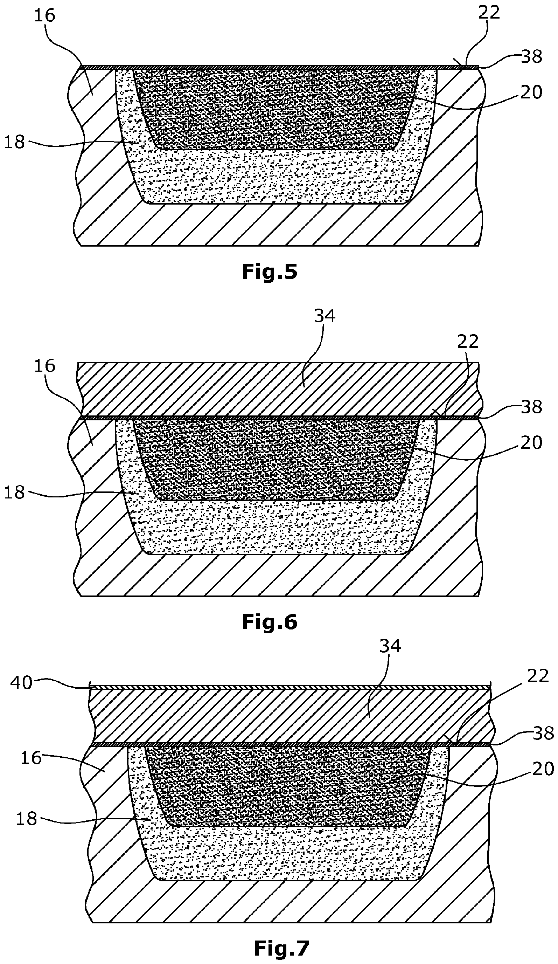

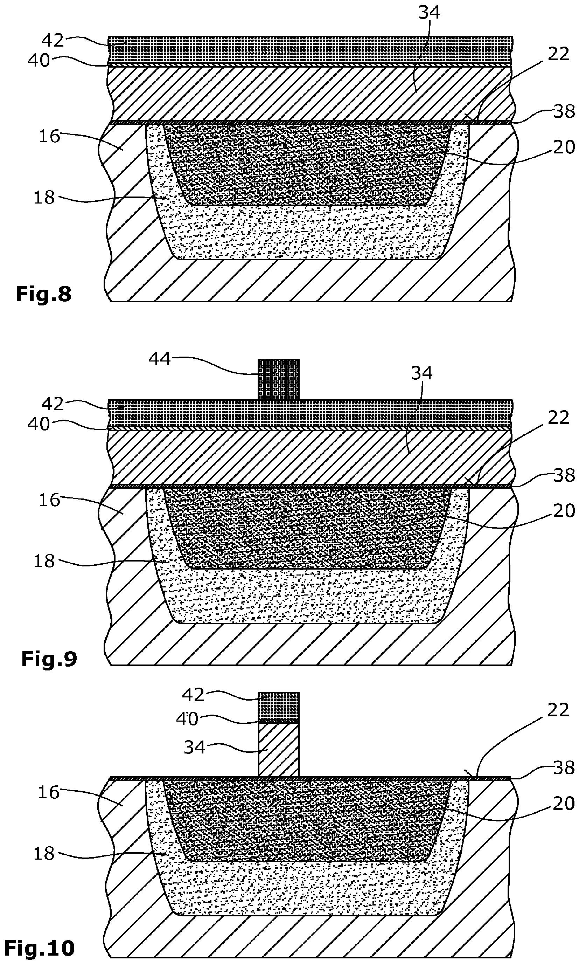

In einem nächsten Prozessschritt wird das Tunnel-Isolationsmaterial, das sich im Bereich 38 der Gate-Isolationsschicht 30 befindet (siehe Fig. 1), erzeugt, und zwar auf der Oberseite 22 des Halbleitersubstrats 16. Auf dieses Tunnel-Isolationsmaterial wird dann das Speichermaterial (in diesem Fall polykristallines Silizium) für das Speicherelement 34 aufgebracht, woraufhin dann auf dieses Speichermaterial ein weiteres Dielektrikum 40 mit einer Hartmaske 42 beispielsweise aus Nitrid aufgebracht wird. Dies ist in den Fign. 5 bis 8 gezeigt. Auf die Nitrid-Hartmaskenschicht 42 wird dann ein Photolack 44 aufgebracht, der strukturiert ist, so dass er lediglich noch im Bereich oberhalb des späteren Speicherelements 34 verbleibt (siehe Fig. 9).

Anschließend wird, wie in Fig. 10 gezeigt, ein Ätzprozess durchgeführt, so dass lediglich noch das Speichermaterial für das Speicherelement 34 verbleibt, das durch das weitere Dielektrikum 40 und die Nitrid-Hartmaskenschicht 42 abgedeckt ist. Unterhalb des Speicherelements 34 verbleibt dann lediglich noch die Tunnel-Isolationsschicht 41.

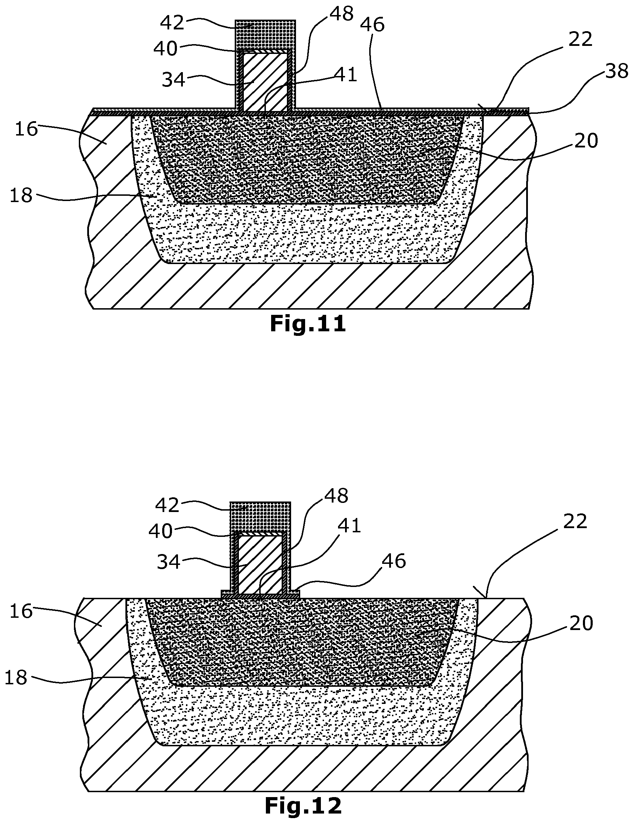

In einem nächsten Prozessschritt (siehe Fig. 11) wird das Tunnel-Isolationsmaterial 38 durch Silizium-Nitrid oder ein anderes Hartmaskenmaterial 46 abgedeckt. Dieses Material 46 legt sich auch an den Außenseiten des aufragenden Speicherelements 34 an, und zwar genauso wie zuvor das Material der Gate-Isolationsschicht 30 (siehe dazu auch Fig. 11 bei 48).

Dann wird die Doppelschicht aus dem Tunnel-Isolationsmaterial 38 und dem Hartmaskenmaterial 46 von der Oberseite 22 des Halbleitersubstrats 16 entfernt (siehe Fig. 12).

Nach diesen Prozessschritten ist also das Speicherelement 34 allseitig von Dielektrikum-Material (nämlich 40, 48) umgeben.

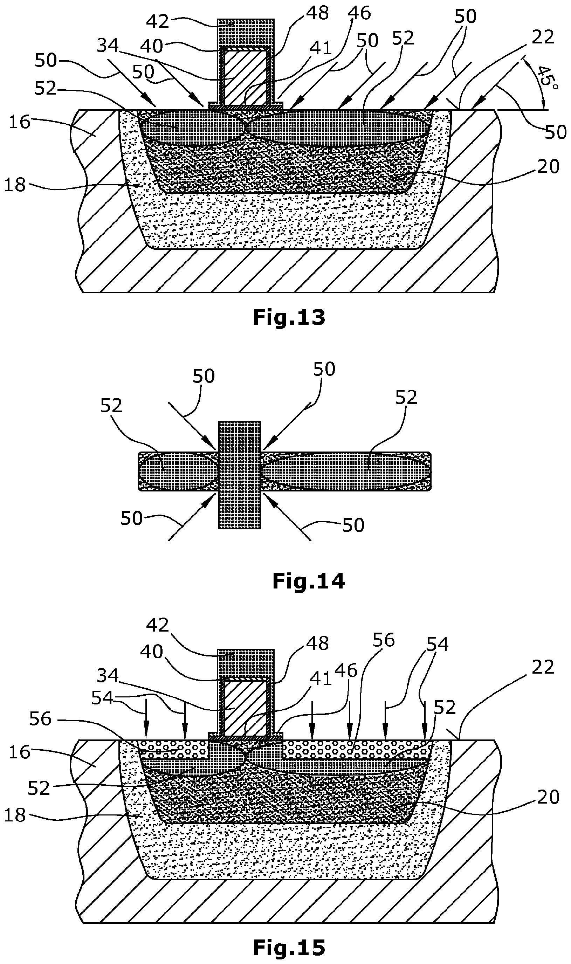

In den Fign. 13 und 14 ist gezeigt, wie zwecks Einstellung der Schwellspannung unterhalb des Speicherelements 34 in die Oberseite 22 des Halbleitersubstrats 16 mehrere Schrägimplantationen 50 von p-Dotierstoff (beispielsweise Bor) eingebracht wird. Die Pfeile zeigen die Neigung der Schrägimplantationen 50 gegenüber der Oberseite 22 des Halbleitersubstrats 16 (in diesem Ausführungsbeispiel 45°). In Fig. 14 ist gezeigt, dass letztendlich die Schrägimplantationen 50 aus vier paarweise jeweils gegenüberliegenden Richtungen in die Oberseite 22 und damit auch bis unterhalb des Speicherelements 34 eingebracht werden.

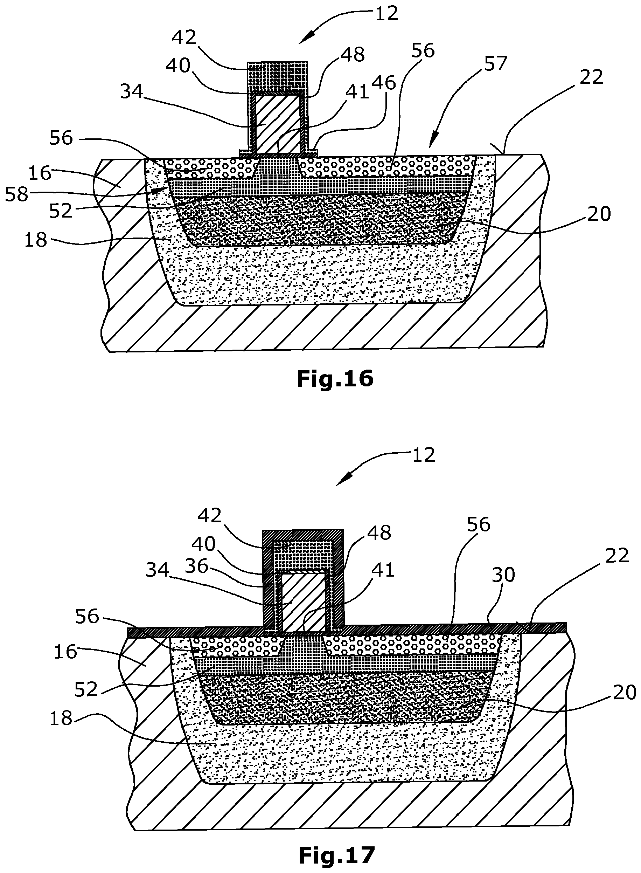

Durch die Schrägimplantationen des p-Dotierstoffs 52 wird selbstverständlich auch die Schwellspannung außerhalb des Speicherelements 34 beeinflusst. Außerhalb des Speicherelements 34 befindet sich aber der eigentliche Steuertransistor 14, der eine niedrigere Schwellspannung als die Schwellspannung unterhalb des Speicherelements 34 aufweisen sollte. Daher wird, wie in Fig. 15 gezeigt, durch eine weitere Implantation 54 eines zweiten n-Dotierstoffs 56 die Dotierung mit dem ersten Dotierstoff 52 außerhalb des Speicherelements 34 kompensiert. Nach thermischer Aktivierung beider Implantationen 50,54 stellt sich die Situation gemäß Fig. 16 ein. In der oberflächennahen Zone 57 ist die Dotierstoff-Konzentration geringer als in der in vertikaler Richtung benachbarten Zone 58. In vertikaler Richtung betrachtet folgt auf diese Zone 58 der untere Teil der p-Wanne 20. Zu erkennen ist, dass die Zone 58, die gegenüber der Zone 57 eine höhere p-Dotierstoff-Konzentration aufweist, sich auch bis unterhalb des Speicherelements 34 erstreckt und damit die Schwellspannung des Speichertransistors 12 bestimmt.

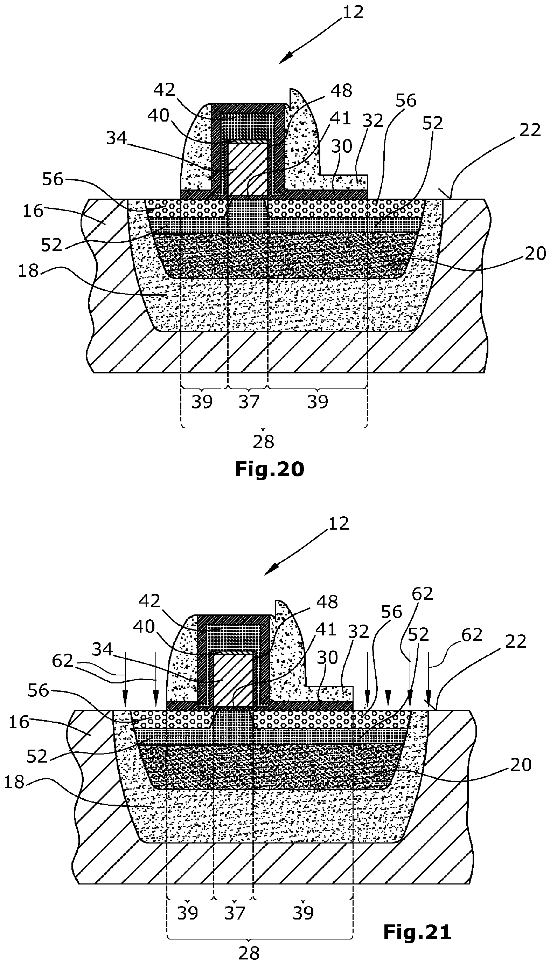

Die nächsten Verfahrensschritte zur Herstellung der Flash-Speicherzelle 10 sind in den Fign. 17 bis 19 gezeigt. Hier geht es um das Aufbringen des Oxids als Gate-Isolationsschicht 30 beidseitig des Speicherelements 34 (siehe Fig. 17), um das Aufbringen einer Schicht aus Elektrodenmaterial (beispielsweise polykristallines Silizium) für die spätere Gate-Elektrode 32 des Steuertransistors 14, wobei infolge der an sich bekannten Spacer-Herstellung sich nun auch allseitig um das aufragende Speicherelement 34 herum dieses Elektrodenmaterial befindet, und schließlich um die Aufbringung einer Photolackschicht 60, die dann strukturiert wird, damit sich nach dem Herunterätzen im Spacer-Prozess der Elektrodenmaterialschicht die Situation gemäß Fig. 20 einstellt. In Fig. 20 ist zu erkennen, dass das Elektrodenmaterial für die Gate-Elektrode 32 des Steuertransistors 14 auf Grund der strukturierten Photolackschicht 60 asymmetrisch stehen bleibt. Es entsteht der vergleichsweise lange Kanalbereich 39 des Steuertransistors 14. Schließlich werden beidseitig der Steuertransistor-Gate-Elektrode 32 in die p-Wanne die Implantationen 62 zur Herstellung der späteren Drain- und Source-Anschlussgebiete 24,26 eingebracht, die in niedriger dotierten Umgebungsgebieten 64,66 angeordnet sein können (siehe Fig. 1).

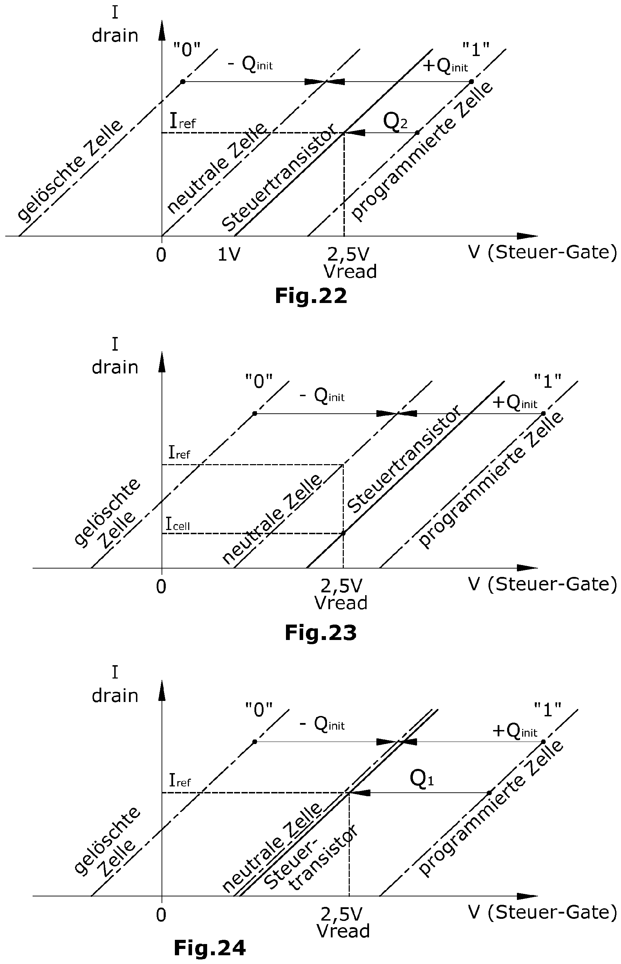

Anhand der Fign. 22 bis 24 soll einer der wesentlichen Aspekte der Erfindung, nämlich die beiden Implantationen des Kanalgebiets unterhalb des Speicherelements einerseits und unterhalb des Steuer-Gates andererseits nochmals verdeutlicht werden. Dabei sind die Kennlinien in den Figuren als gerade Linien und damit stark schematisiert dargestellt.

Mit "neutrale Zelle" ist die Kennlinie des Speichertransistors in dem Zustand des Speicherelements bezeichnet, in dem weder Ladungen aufgebracht noch Ladungen entzogen sind. Mit "programmierte Zelle" ist die Kennlinie des Speichertransistors beizeichnet, in dem die Ladung Qᵢₙᵢₜ auf/in das Speicherelement auf-/eingebracht ist. Dieser Zustand enstpricht der Information "binär EINS". Mit "gelöschte Zelle" ist die Kennlinie in demjenigen Zustand des Speichertransistors bezeichnet, in dem die Ladungsmenge Qᵢₙᵢₜ dem Speicherelement entzogen ist. Dieser Zustand entspricht beispielsweise der Information "binär NULL". Die Zeilen unter + Qᵢₙᵢₜ und - Qᵢₙᵢₜ geben an, dass sich die jeweils in Bezug auf die neutrale Zelle verschobenen Kennlinien wegen der nicht zu vermeidenden Entladung bzw. allgemein Ladungsveränderung des Speicherelements wieder in Richtung auf die Kennlinie für die neutrale Zelle zurückbewegen. Mit "Steuertransistor" ist die Kennlinie des Steuertransistors gemeint.

Fig. 22 zeigt die Situation bei einer nicht erfindungsgemäß implantierten Flash-Speicherzelle. Q₂ ist die maximale Ladung, die die Zelle verlieren darf, damit die Information "binär EINS" noch korrekt ausgelesen werden kann. Bei der einfachen Kanalimplantation wie im Stand der Technik bekannt, liegt also die Schwellspannung der neutralen Zelle unter der Schwellspannung des Steuertransistors. Damit "maskiert" die Kennlinie des Steuertransistors nicht nur den komplett gelöschten Bereich (binär NULL), sondern auch einen Teil des programmierten Bereichs (binär EINS). D. h., dass eine relativ große Menge an Ladung, nämlich Q₂, in dem Speicherelement enthalten bleiben muss, damit der programmierte Zustand (binär EINS) noch sicher ausgelesen werden kann.

Fig. 23 zeigt die Kennlinien für den Fall, dass die erfindungsgemäß vorgesehene erste Implantation, d. h. die Schräg-Implantation unter dem Speicherelement vorhanden ist. Im Vergleich zur Situation in Fig. 22 sind nun sämtliche Kennlinien in gleichem Maße nach rechts verschoben. Die Zelle funktioniert nicht, weil der Steuertransistor nicht ausreichend geöffnet werden kann. Bei dieser ersten Implantation werden beide Kennlinien, nämlich für die neutrale Zelle und für den Steuertransistor, nach rechts verschoben. Bei der gleichen Ladungsmenge Qᵢₙᵢₜ im Speicherelement liegt jetzt die Schwellspannung der programmierten Zelle höher. Die Zelle kann nicht bestimmungsgemäß arbeiten, da durch Erhöhung der Schwellspannung des Steuertransistors dieser nicht ausreichend Strom liefern kann.

In Fig. 24 ist die Kennliniensituation nach erfolgter zweiter erfindungsgemäßer Implantation (Kompensations-Implantation) gezeigt. Die Kennlinie des Steuertransistors ist im Vergleich zur Situation nach Fig. 23 zurückversetzt, so dass jetzt die Ladungsmenge Q₁, um die sich die zur korrekten Auslesbarkeit jeweils eines der beiden Informationszustände (binär EINS und binär NULL) erforderliche Ladung verändern darf, wesentlich größer als im oben beschriebenen Fall für die Ladungsmenge Q₂. Die zweite Kompensation-Implantation beseitigt also den Umstand, dass die Flash-Speicherzelle, die lediglich die Schrägimplantation unterhalb ihres Speicherelements aufweist, nicht funktioniert. Die zweite Implantation bringt die Kennlinie des Steuertransistors wieder an ihre "ursprüngliche" Stelle. Jetzt liegt die Kennlinie des Steuertransistors nahe bei der Kennlinie der neutralen Zelle und das komplette Programmierfenster kann ausgenutzt werden. D. h., dass die Flash-Speicherzelle nun mehr Ladung verlieren darf, bis der programmierbare Zustand nicht mehr ausgelesen werden kann.

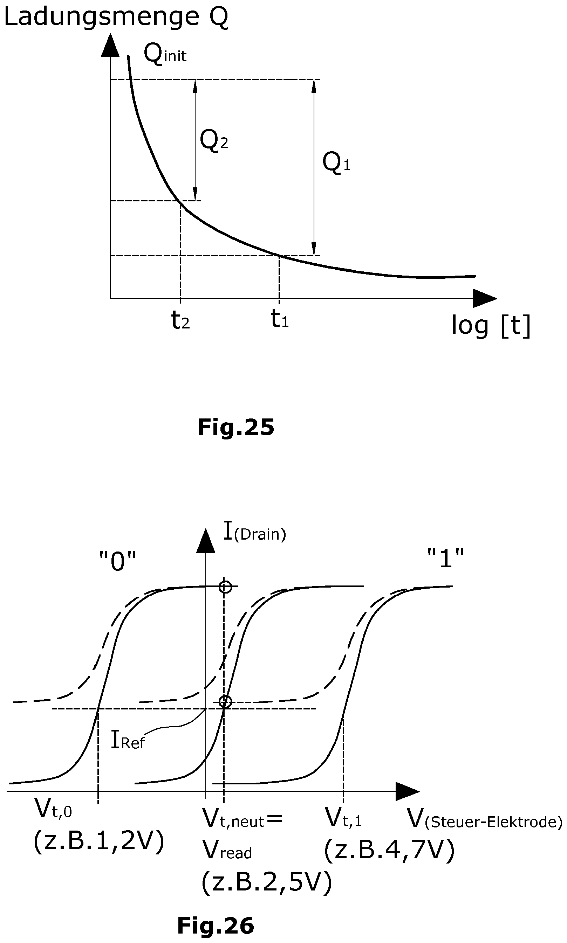

Die die Entladungskurve des Speicherelements exponentiell abfallend ist (siehe Fig. 25), führt die "lineare" Erhöhung des für das ordnungsgemäße Auslesen der Information "nutzbaren" Entladungsfenster zu einer exponentiellen zeitlichen Verlängerung des Datenerhalts in der Flash-Speicherzelle.

Bekannte Kurzkanal-Zellen weisen bei steigenden Temperaturen stark steigende Leckströme auf, wie die in Fig. 26 gestrichelt dargestellte Strom/Spannungs-Charakteristik zeigt. Die Zellen mit "0" Zustand weisen einen Leckstrom auf, der oberhalb des Vergleichsstroms I_{Ref} liegt, d. h. Zellen mit "0" und "1" würden jeweils als "0" gelesen. Der hohe Leckstrom ist auf Kurzkanaleffekte zurückzuführen. Durch die Verlängerung des Steuer-Gates nach der Erfindung werden die Kurzkanaleffekte vermindert (durchgezogene Kennlinien in Fig. 26). Auch bei Temperaturen um 150° ist noch ein vertretbar geringer Leckstrom vorhanden und "1" programmierte Zellen können als "1" gelesen werden.

### BEZUGSZEICHENLISTE

- 10: Flash-Speicherzelle
- 12: Speichertransistor der Flash-Speicherzelle
- 14: Steuertransistor der Flash-Speicherzelle
- 16: Halbleitersubstrat
- 18: Doppelwannenstruktur im Halbleitersubstrat
- 22: Oberseite des Halbleitersubstrats
- 24: Drain-Anschlussgebiet
- 26: Source-Anschlussgebiet
- 28: Kanalgebiet
- 30: Gate-Isolationsschicht
- 31: Gate-Isolationsschichtbereich unterhalb des Speicherelements
- 32: Steuertransistor-Gate-Elektrode
- 34: Speicherelement
- 35: Material der Gate-Elektrode um Speicherelement herum
- 36: Dielektrikum
- 37: Kanalbereich unterhalb des Speicherelements
- 38: Tunnel-Isolationsmaterial unterhalb des Speicherelements
- 39: Steuerkanal des Steuertransistors
- 40: Dielektrikum
- 41: Tunnel-Isolationsschicht
- 42: Nitrid-Hartmaskenschicht
- 44: Photolack
- 46: Hartmaskenmaterial
- 48: Dielektrikum
- 50: Schrägimplantation zur Einstellung der Schwellspannung unterhalb des Speicherelements
- 52: erster Dotierstoff
- 54: Implantation zur Einstellung der Schwellspannung unterhalb der Steuertransistor-Gate-Elektrode
- 56: (zweiter) Kompensationsdotierstoff
- 57: oberflächennahe Zone des Halbleitersubstrats
- 58: benachbarte Zone zur oberflächennahen Zone
- 60: Photolackschicht
- 62: Implantationen für Drain und Source
- 64: Umgebungsgebiet um Drain
- 66: Umgebungsgebiet um Source

## Patentansprüche

1. Flash-Speicherzelle, die durch Anlegen von Programmier- und Löschspannungen beschreibbar sowie löschbar und durch Anlegen einer Lesespannung auslesbar ist, mit
- einem Halbleitersubstrat (16), das eine Oberseite (22) aufweist,
- in die Oberseite (22) des Halbleitersubstrats (16) eingebrachten, voneinander beabstandeten Drain- und Source-Anschlussgebieten (24,26),
- einer Gate-Isolationsschicht (30, 41), die auf der Oberseite (22) des Halbleitersubstrats (16) zwischen dem Drain- und dem Source-Anschlussgebiet (24,26) angeordnet ist,
- einem von der Gate-Isolationsschicht (41) aufragenden Speicherelement (34) aus einem Speichermaterial für elektrische Ladung, die durch Erzeugen eines Tunnelstroms durch den unterhalb des Speicherelements (34) angeordneten Bereich (37) der Gate-Isolationsschicht (41) hindurch elektrisch auf- und entladbar ist, und
- einer die Gate-Isolationsschicht (30) überdeckenden, das Speicherelement (34) allseitig umgebenden sowie gegenüber diesem durch ein Dielektrikum (44,48) elektrisch isolierten Steuertransistor-Gate-Elektrode (32) zur Erzeugung eines wahlweise elektrisch leitenden oder sperrenden Kanals unterhalb der Steuertransistor-Gate-Elektrode (32),
**dadurch gekennzeichnet,**
- **dass** das Speicherelement (34) dezentral zwischen den Drain- und Source-Anschlussgebieten (24,26) und mit jeweiligem lateralen Abstand zu beiden positioniert ist und
- **dass** die Oberseite (22) des Halbleitersubstrats (16) unterhalb der Gate-Isolationsschicht (30) in einem Bereich zwischen dem Drain- und dem Source-Anschlussgebiet (24,26) ein laterales Dotierstoffprofil aufweist, das im Bereich unterhalb des Speicherelements (34) zur Einstellung einer ersten Schwellspannung einen Dotierstoff von einem ersten Leitungstyp und im Bereich unterhalb der Steuertransistor-Gate-Elektrode (32) zur Einstellung einer im Vergleich zur ersten Schwellspannung geringeren zweiten Schwellspannung den ersten Dotierstoff (52) und einen zweiten Kompensationsdotierstoff (56) von einem zum ersten Leitungstyp entgegengesetzten zweiten Leitungstyp aufweist.

2. Flash-Speicherzelle nach Anspruch 1, **dadurch gekennzeichnet, dass** die Gate-Isolationsschicht (30, 41) in ihrem Bereich unterhalb des Speicherelements (34) dünner ist als in ihrem Bereich unterhalb der Steuertransistor-Gate-Elektrode (32).

3. Flash-Speicherzelle nach Anspruch 1 oder 2, **dadurch gekennzeichnet, dass** das Speicherelement (34) über seine gesamte Höhe oder über seine gesamte Höhe sowie darüber hinaus von dem Dielektrikum (42,48) und der Steuertransistor-Gate-Elektrode (32) umgeben ist.

4. Flash-Speicherzelle nach Anspruch 3, **dadurch gekennzeichnet, dass** die Steuertransistor-Gate-Elektrode (32) polykristallines Silizium aufweist.

5. Flash-Speicherzelle nach einem oder mehreren der Ansprüche 1 bis 4, **dadurch gekennzeichnet, dass** das Speicherelement (34) polykristallines Silizium aufweist.

6. Verfahren zur Herstellung einer Flash-Speicherzelle nach einem der vorstehenden Ansprüche, bei dem
- ein Halbleitersubstrat (16) mit einer Oberseite (22) bereitgestellt wird, in die ein Drain- und ein Source-Anschlussgebiet (24,26) eingebracht sind und auf der in einem dezentral und im Abstand zu den Drain- und Source-Gebieten (24,26) gelegenen Teilbereich zwischen dem Drain- und dem Source-Anschlussgebiet (24,26) eine erste Gate-Isolationsschicht (41) aufgebracht ist, von der ein Speicherelement (34) aus Speichermaterial für elektrische Ladung aufragt,
- im spitzen Winkel von einer Seite oder allseitig des Speicherelements (34) aus in die Oberfläche des Halbleitersubstrats (16) und damit auch schräg unterhalb des Speicherelements (34) erste Ionen zum örtlichen Dotieren des Halbleitersubstrats (16) mit einem ersten Dotierstoff (52) eines ersten Leitungstyps zwecks Einstellung einer ersten Schwellspannung im Bereich unter dem Speicherelement (34) implantiert werden,
- in den Bereich der Oberfläche des Halbleitersubstrats (16) zwischen den Drain- und Source-Anschlussgebieten (24,26) sowie außerhalb des Speicherelements (34) zur Kompensation der dort implantierten ersten Ionen zweite Ionen zur örtlichen Kompensationsdotierung mit einem zweiten Dotierstoff (56) von einem dem ersten Leitungstyp entgegengesetzten zweiten Leitungstyp zwecks Einstellen einer gegenüber der ersten Schwellspannung geringeren zweiten Schwellspannung im Bereich außerhalb des Speicherelements (34) implantiert werden und
- eine zweite Gate-Isolationsschicht (30) lateral zur ersten Gate-Isolationsschicht (41) auf der Oberseite (22) des Halbleitersubstrats (16) zwischen den Drain- und Source-Anschlussgebieten (24,26) mit einer das Speicherelement (34) allseitig umgebenden und gegebenenfalls dieses überdeckenden Steuertransistor-Gate-Elektrode (32) ausgebildet wird.

7. Verfahren nach Anspruch 6, **dadurch gekennzeichnet, dass** die Schrägimplantation in mehreren, insbesondere vier Implantationsschritten erfolgt, wobei der erste Dotierstoff (52) von Implantationsschritt zu Implantationsschritt jeweils in unterschiedlichen, insbesondere gleichmäßig versetzten Raumwinkeln implantiert wird.

8. Verfahren nach Anspruch 6 oder 7, **dadurch gekennzeichnet, dass**, zur Herstellung der Steuertransistor-Gate-Elektrode (32), das Speicherelement (34) und zumindest die zweite Gate-Isolationsschicht (30) von einem Gate-Elektrodenmaterial überdeckt wird und dass das Gate-Elektrodenmaterial bis in Höhe der Oberseite (22) des aufragenden Speicherelements (34) oder oberhalb dessen heruntergeätzt wird, wobei durch Maskierung (60) des größeren der beiden Abstandsbereiche des Speicherelements (34) zu den Drain- und Source-Anschlussgebieten (24,26) Gate-Elektrodenmaterial zur Erzeugung eines Kanalgebiets auf der Oberseite (22) des Halbleitersubstrats (16) mit einer Länge gebildet wird, die durch den längeren der beiden Abstandsbereiche definiert ist.

## Claims

1. A flash memory cell which is writable and erasable by application of programming and erase voltages and is readable by application of a read voltage comprising
- a semiconductor substrate (16) comprising a top side (22),
- mutually spaced drain and source connection areas (24,26) formed in the top side (22) of the semiconductor substrate (16),
- a gate insulation layer (30,41) arranged on the top side (22) of the semiconductor substrate (16) between the drain and source connection areas (24,26),
- a memory element (34) projecting from the gate insulation layer (41) and made of a storage material for electric charge, the memory element being chargeable and dischargeable by generating a tunnel current through the area (37) of the gate insulation layer (41) arranged below the memory element (34),
- a control transistor gate electrode (32) covering the gate insulation layer (30) and surrounding the memory element (34) on all sides and being electrically insulated therefrom by a dielectric (44,48), the control transistor gate electrode being provided for generating a selectively electrically conducting or blocking channel below the control transistor gate electrode (32),
**characterized in**
- **that** the memory element (34) is positioned in a decentralized manner between the drain and source connection areas (24,26) and with respective lateral distance to both areas, and
- **that** the top side (22) of the semiconductor substrate (16) comprises, below the gate insulation layer (30) in a region between the drain and source connection areas (24,26), a lateral dopant profile which, in the region below the memory element (34), comprises a dopant of a first conductance type for setting a first threshold voltage, and, in the region below the control transistor gate electrode (32), comprises the first dopant (52) and a second compensation dopant (56) of a second conductance type opposed to the first conductance type, for setting a second threshold voltage which is lower than the first threshold voltage.

2. The flash memory cell according to claim 1, **characterized in that** the gate insulation layer (30,41) is thinner in its region below the memory element (34) than in its region below the control transistor gate electrode (32).

3. The flash memory cell according to claim 1 or 2, **characterized in that** the memory element (34) is surrounded by the dielectric (42,48) and by the control transistor gate electrode (32) along its entire height or along its entire height and beyond its entire height.

4. The flash memory cell according to claim 3, **characterized in that** the control transistor gate electrode (32) comprises polycrystalline silicon.

5. The flash memory cell according to any one or a plurality of claims 1 to 4, **characterized in that** the memory element (34) comprises polycrystalline silicon.

6. A method for producing a flash memory cell according to any one of the preceding claims, wherein
- a semiconductor substrate (16) is provided, comprising a top side (22) in which a drain and a source connection area (24,26) are formed and on which, in a partial region situated in a decentralized position and with a distance to the drain and a source connection areas (24,26), a first gate insulation layer (41) is applied between the drain and source connection areas (24,26), first gate insulation layer having projecting from it a memory element (34) made of a storage material for electric charge,
- at an acute angle from one side or all sides of the memory element (34), first ions are implanted into the surface of the semiconductor substrate (16) and thus also obliquely below the memory element (34), for locally doping the semiconductor substrate (16) with a first dopant (52) of a first conductance type, for setting a first threshold voltage in the region below the memory element (34),
- into the region of the surface of the semiconductor substrate (16) between the drain and source connection areas (24,26) as well as outside the memory element (34), for compensation of the first ions implanted there, second ions are implanted for local compensation doting with a second dopant (56) of a second conductance type opposed to the first conductance type, for setting, in the region outside the memory element (34), a second threshold voltage which is lower than the first threshold voltage, and
- a second gate insulation layer (30) is formed laterally of the first gate insulation layer (41) on the top side (22) of the semiconductor substrate (16) between the drain and source connection areas (24,26), the gate insulation layer being provided with a control transistor gate electrode (32) surrounding the memory element (34) on all sides and optionally covering the same.

7. The method according to claim 6, **characterized in that** said oblique implantation is performed in a plurality of implantation steps, preferably in preferably four implantation steps, wherein the first dopant (52) is being implanted, from implantation step to implantation step, each time in different spatial angles preferably displaced in a uniform manner.

8. The method according to claim 6 or 7, **characterized in that**, for producing the control transistor gate electrode (32), the memory element (34) and at least the second gate insulation layer (30) is covered by a gate electrode material, and that the gate electrode material is etched down to the level of the top side (22) of the projecting memory element (34) or to a level thereabove, wherein, by masking the larger one of the two distance regions of the memory element (34) to the drain and source connection areas (24,26), gate electrode material is formed for generating, on the top side (22) of the semiconductor substrate (16), a channel area of a length which is defined by the longer one of the two distance regions.

## Revendications

1. Cellule de mémoire flash qui est inscriptible ainsi qu'effaçable par l'application de tensions de programmation et d'effacement et qui est lisible par l'application d'une tension de lecture, avec
- un substrat semi-conducteur (16) qui présente un côté supérieur (22),
- des zones de raccordement de drains et de sources (24, 26) mises en place dans le côté supérieur (22) du substrat semi-conducteur (16) et espacées les unes des autres,
- une couche d'isolation de grille (30, 41),
qui est disposée sur le côté supérieur (22) du substrat semi-conducteur (16) entre la zone de raccordement de drain et la zone de raccordement de source (24, 26),
- un élément de mémoire (34) dépassant de la couche d'isolation de grille (41) et réalisé dans un matériau de mémoire pour charge électrique qui peut être chargée et déchargée électriquement par la production d'un courant tunnel à travers la région (37) de la couche d'isolation de grille (41) disposée au-dessous de l'élément de mémoire (34), et
- une électrode de grille de transistor de commande (32), qui recouvre la couche d'isolation de grille (30), entoure de tous côtés l'élément de mémoire (34) tout en étant électriquement isolée de celui-ci par un diélectrique (44, 48), destinée à la production d'un canal au choix électriquement conducteur ou bloquant au-dessous de l'électrode de grille de transistor de commande (32),
**caractérisée en ce que**
- l'élément de mémoire (34) est positionné de façon décentrée entre les zones de raccordement de drains et de sources (24, 26) et avec un espacement latéral respectif par rapport aux deux zones, et
- le côté supérieur (22) du substrat semi-conducteur (16) présente, au-dessous de la couche d'isolation de grille (30), dans une région entre la zone de raccordement de drains et la zone de raccordement de sources (24, 26), un profil de dopant latéral qui présente, dans la région au-dessous de l'élément de mémoire (34), pour le réglage d'une première tension de seuil, un dopant d'un premier type de conduction, et qui présente, dans la région au-dessous de l'électrode de grille de transistor de commande (32), pour le réglage d'une deuxième tension de seuil plus faible comparée à la première tension de seuil, le premier dopant (52) et un deuxième dopant de compensation (56) d'un deuxième type de conduction opposé au premier type de conduction.

2. Cellule de mémoire flash selon la revendication 1, **caractérisée en ce que**, dans sa région au-dessous de l'élément de mémoire (34), la couche d'isolation de grille (30, 41) est plus mince que dans sa région au-dessous de l'électrode de grille de transistor de commande (32).

3. Cellule de mémoire flash selon la revendication 1 ou 2, **caractérisée en ce que**, sur toute sa hauteur ou sur toute sa hauteur ainsi qu'au-delà, l'élément de mémoire (34) est entouré par le diélectrique (42, 48) et par l'électrode de grille de transistor de commande (32).

4. Cellule de mémoire flash selon la revendication 3, **caractérisée en ce que** l'électrode de grille de transistor de commande (32) présente du silicium polycristallin.

5. Cellule de mémoire flash selon l'une ou plusieurs des revendications 1 à 4, **caractérisée en ce que** l'élément de mémoire (34) présente du silicium polycristallin.

6. Procédé de fabrication d'une cellule de mémoire flash selon l'une des revendications précédentes, dans lequel
- un substrat semi-conducteur (16) est fourni avec un côté supérieur (22) dans lequel sont insérées une zone de raccordement de drains et une zone de raccordement de sources (24, 26), et sur lequel une première couche d'isolation de grille (41) est mise en place dans une région partielle placée de façon décentrée et à distance des zones de raccordement de drain et de source (24, 26) entre la zone de raccordement de drain et la zone de raccordement de source (24, 26), un élément de mémoire (34) en matériau de mémoire pour charge électrique dépassant de ladite couche d'isolation de grille,
- des premiers ions destinés au dopage local du substrat semi-conducteur (16) avec un premier dopant (52) d'un premier type de conduction sont implantés, selon un angle aigu à partir d'un côté ou de tous les côtés de l'élément de mémoire (34), dans la surface du substrat semi-conducteur (16) et donc également de façon oblique au-dessous de l'élément de mémoire (34) à des fins de réglage d'une première tension de seuil dans la région sous l'élément de mémoire (34),
- des deuxièmes ions destinés au dopage de compensation local avec un deuxième dopant (56) d'un deuxième type de conduction opposé au premier type de conduction sont implantés dans la région de la surface du substrat semi-conducteur (16) entre les zones de raccordement de drain et de source (24, 26) ainsi qu'à l'extérieur de l'élément de mémoire (34) pour la compensation des premiers ions qui y sont implantés, à des fins de réglage d'une deuxième tension de seuil plus faible par rapport à la première tension de seuil dans la zone à l'extérieur de l'élément de mémoire (34), et
- une deuxième couche d'isolation de grille (30) est constituée latéralement par rapport à la première couche d'isolation de grille (41) sur le côté supérieur (22) du substrat semi-conducteur (16) entre les zones de raccordement de drain et de source (24, 26) avec une électrode de grille de transistor de commande (32) entourant de tous côtés l'élément de mémoire (34) et recouvrant éventuellement celui-ci.

7. Procédé selon la revendication 6, **caractérisé en ce que** l'implantation oblique s'effectue en plusieurs étapes, en particulier en quatre étapes d'implantation, le premier dopant (52) étant implanté d'étape d'implantation en étape d'implantation respectivement selon des angles solides différents, en particulier décalés de façon régulière.

8. Procédé selon la revendication 6 ou 7, **caractérisé en ce que**, pour la fabrication de l'électrode de grille de transistor de commande (32), l'élément de mémoire (34) et au moins la deuxième couche d'isolation de grille (30) sont recouverts par un matériau d'électrode de grille, et **en ce que** le matériau d'électrode de grille est soumis à une gravure vers le bas jusqu'à hauteur du côté supérieur (22) de l'élément de mémoire (34) en saillie ou au-dessus de celui-ci, le matériau d'électrode de grille étant formé par le masquage (60) de la plus grande des deux plages d'espacement de l'élément de mémoire (34) par rapport aux zones de raccordement de drains et de sources (24, 26) pour la production d'une zone de canal sur le côté supérieur (22) du substrat semi-conducteur (16), avec une longueur qui est définie par la plus longue des deux plages d'espacement.
